# EUROPEAN PATENT APPLICATION

(11) **EP 4 390 698 A1**
(43) Date of publication of application: **26.06.2024**
(21) Application number: 22871851.6
(22) Date of filing: 13.09.2022
(51) Int. Cl.: G06F 11/10

(54) **MEMORY ERROR CORRECTION METHOD AND APPARATUS, AND RELATED DEVICE**

(30) Priority: 27.09.2021 CN 202111137528
(71) Applicant: Huawei Technologies Co., Ltd., Shenzhen, Guangdong 518129 (CN)
(72) Inventor: PAN, Wei, Shenzhen, Guangdong 518129 (CN); CHEN, Zhiyong, Shenzhen, Guangdong 518129 (CN)
(74) Representative: Gill Jennings & Every LLP
(86) International application number: PCT/CN2022/118458
(87) International publication number: WO 2023/045803

(57) **Abstract**

Embodiments of this application provide a memory error correction method and apparatus, and a related device, which are applied to the field of computers. The method may include: determining that a memory error exists in first memory data, where the memory error includes an error that cannot be corrected in the first memory data within a preset time period or a preset quantity of times; reading the first memory data when a memory channel is idle; and performing memory error correction on the first memory data based on an error correction algorithm. According to embodiments of this application, an error that cannot be corrected within a preset time period or a preset quantity of times can be corrected without affecting normal data communication, to improve data reliability.

## Description

This application claims priority to Chinese Patent Application No. 202111137528.X, filed with the China National Intellectual Property Administration on September 27, 2021 and entitled "MEMORY ERROR CORRECTION METHOD AND APPARATUS, AND RELATED DEVICE", which is incorporated herein by reference in its entirety.

### TECHNICAL FIELD

This application relates to the field of computer technologies, and in particular, to a memory error correction method and apparatus, and a related device.

### BACKGROUND

In the field of computers, reliability of memory data, especially system core data or important application data, is critical to performance of an entire system, and reliability of the data directly affects running of the entire system. Therefore, a data error correction technology emerges. Whether current data is correct data is determined by using the error correction technology and a predetermined error correction algorithm, to determine reliability of the currently read data.

Generally, an error correction code (Error Correction Code, ECC) technology is used to implement data error correction. Although an ECC error correction technology has an error check capability and an error correction capability, the error correction capability is only applicable to error correction performed on memory data within a preset quantity of times or a preset time period. If memory error correction on the memory data is not completed within the preset quantity of times or the preset time period, correction on the memory data is abandoned. Therefore, the error correction capability for memory data is limited, and an application requirement for ensuring data reliability cannot be met.

### SUMMARY

Embodiments of this application provide a memory error correction method and apparatus, and a related device, so that an error that cannot be corrected within a preset time period or a preset quantity of times can be corrected without affecting normal data communication, to improve data reliability.

According to a first aspect, an embodiment of this application provides a memory error correction method, where the method may include: determining that a memory error exists in first memory data, where the memory error includes an error that cannot be corrected in the first memory data within a preset time period or a preset quantity of times; reading the first memory data when a memory channel is idle; and performing memory error correction on the first memory data.

The foregoing method may be applied to a server, and is performed by the server or a component (for example, a chip, a software module, or an integrated circuit) in the server.

Generally, if error correction on the memory data can be completed within the preset time period or the preset quantity of times, error correction can be directly performed on the memory data and the memory data can be written back. If error correction on the memory data cannot be completed within the preset time period or the preset quantity of times, it indicates that the memory error in the memory data requires more time or more quantity of times to be corrected. In the foregoing case, in current technologies, the memory error is ignored, and the memory data having the foregoing memory error is not corrected. In this embodiment of this application, when normal data communication is not affected, in other words, when the memory channel is idle, the first memory data having the memory error may be read, and memory error correction is performed on the first memory data. Therefore, an error correction capability can be maximized to ensure data reliability.

In a possible implementation of the first aspect, before the determining that a memory error exists in first memory data, and after the reading the first memory data when a memory channel is idle, the method further includes: storing a first address of the first memory data in a register of a memory controller.

It can be learned that, the register is a storage area used to store data in the memory controller. The address of the first memory data is stored in the register, so that when the memory channel is idle, the memory controller can quickly read the memory data based on the address stored in the register.

In a possible implementation of the first aspect, the reading the first memory data when a memory channel is idle includes: when the memory channel is idle, reading the first memory data based on the first address stored in the register.

It can be learned that, the register stores the address of the memory data having the memory error. Therefore, when the memory channel is idle, the memory data can be read by using the address stored in the register, to improve a speed of performing error correction on the memory data.

In a possible implementation of the first aspect, the performing memory error correction on the first memory data includes: performing memory error correction on the first memory data when a first tag exists in the read first memory data, where the first tag identifies that the memory error exists in the first memory data.

It can be learned that, to avoid a waste of resources, for example, to avoid performing error correction on data that does not require error correction, error correction is performed on the memory data when the read data has a flag that identifies the memory error.

In a possible implementation of the first aspect, the performing memory error correction on the first memory data includes: stopping performing memory error correction on the first memory data when a read operation or a write operation is performed on the read first memory data in a process of performing memory error correction on the first memory data.

It can be learned that, to avoid system disorder, for example, to avoid performing error correction on data on which a read operation or a write operation is performed, memory error correction performed on the first memory data is stopped when the read operation or the write operation is performed on the read first memory data in a process of performing memory error correction on the first memory data. In other words, error correction needs to be performed on the memory data when no read operation or write operation is performed on the memory data.

In a possible implementation of the first aspect, the performing memory error correction on the first memory data based on an error correction algorithm includes: dividing the first memory data into two or more parts, where each part includes data bits corresponding to a plurality of memory chips; and flipping a first data bit in a first part, keeping flipped data unchanged, and sequentially flipping a plurality of second data bits in a second part until data obtained through flipping is successfully checked, where the first part is any one of the two or more parts, and the second part includes a part of the two or more parts except the first part.

It can be learned that, error correction is performed on the first memory data by dividing two or more parts, so that efficiency and accuracy of trial-and-error can be improved.

In a possible implementation of the first aspect, after the performing memory error correction on the first memory data based on an error correction algorithm, the method further includes: writing the first memory data on which memory error correction is performed back to a memory unit corresponding to the first address.

According to a second aspect, an embodiment of this application provides a memory error correction apparatus, where the apparatus may include:
a processing unit, configured to determine that a memory error exists in first memory data, where the memory error includes an error that cannot be corrected in the first memory data within a preset time period or a preset quantity of times; and
a communication unit, configured to read the first memory data when a memory channel is idle, where
the processing unit is further configured to perform memory error correction on the first memory data.

In a possible implementation of the second aspect, the processing unit is further configured to:
store a first address of the first memory data in a register of a memory controller.

In a possible implementation of the second aspect, the communication unit is specifically configured to:
read the first memory data based on the first address stored in the register.

In a possible implementation of the second aspect, the processing unit is specifically configured to:
perform memory error correction on the first memory data when a first tag exists in the read first memory data, where the first tag identifies that the memory error exists in the first memory data.

In a possible implementation of the second aspect, the processing unit is specifically configured to:
stop performing memory error correction on the first memory data when a read operation or a write operation is performed on the read first memory data in a process of performing memory error correction on the first memory data.

In a possible implementation of the second aspect, the processing unit is specifically configured to:
divide the first memory data into two or more parts, where each part includes data bits corresponding to a plurality of memory chips; and
flip a first data bit in a first part, keep flipped data unchanged, and sequentially flip a plurality of second data bits in a second part until data obtained through flipping is successfully checked, where the first part is any one of the two or more parts, and the second part includes a part of the two or more parts except the first part.

In a possible implementation of the second aspect, the communication unit is further configured to:
write the first memory data on which memory error correction is performed back to a memory unit corresponding to the first address.

According to a third aspect, an embodiment of this application provides a computing device. The computing device includes a processor and a memory. The memory stores a computer program. When the processor executes the computer program, the computing device performs the method described in any one of the first aspect or the second aspect.

It should be noted that, the processor included in the computing device described in the third aspect may be a processor (referred to as a dedicated processor for ease of differentiation) specially configured to perform these methods, or may be a processor that performs these methods by invoking a computer program, for example, a general-purpose processor. Optionally, the at least one processor may further include both a dedicated processor and a general-purpose processor.

Optionally, the computer program may be stored in the memory. For example, the memory may be a non-transitory (non-transitory) memory, for example, a read-only memory (Read Only Memory, ROM). The memory and the processor may be integrated into a same device, or may be separately disposed on different devices. A type of the memory and a manner of disposing the memory and the processor are not limited in embodiments of this application.

In a possible implementation, the at least one memory is located outside the computing device.

In another possible implementation, the at least one memory is located in the computing device.

In still another possible implementation, some memories of the at least one memory are located in the computing device, and the other memories are located outside the computing device.

In this application, the processor and the memory may be alternatively integrated into one device. In other words, the processor and the memory may be alternatively integrated together.

According to a fourth aspect, an embodiment of this application provides a computer-readable storage medium. The computer-readable storage medium stores instructions. When the instructions are run on at least one processor, the method described in any one of the first aspect or the second aspect is implemented.

According to a fifth aspect, this application provides a computer program product, where the computer program product includes computer instructions, and when the instructions are run on at least one processor, the method described in any one of the first aspect and the second aspect is implemented. The computer program product may be a software installation package. When the foregoing method needs to be used, the computer program product may be downloaded and executed on the computing device.

For beneficial effects of the technical solutions provided in the second aspect to the fifth aspect of this application, refer to beneficial effects of the technical solutions in the first aspect. Details are not described herein again.

### BRIEF DESCRIPTION OF DRAWINGS

The following describes the accompanying drawings used in embodiments of this application.
FIG. 1 is a schematic diagram of a memory according to an embodiment of this application;
FIG. 2 is a schematic diagram of a structure of a computer system according to an embodiment of this application;
FIG. 3 is a schematic flowchart of a memory error correction method according to an embodiment of this application;
FIG. 4(a) and FIG. 4(b) are schematic diagrams of performing memory error correction on memory data according to an embodiment of this application;
FIG. 5 is a schematic diagram of a structure of a memory error correction apparatus according to an embodiment of this application; and
FIG. 6 is a schematic diagram of a structure of a computing device according to an embodiment of this application.

### DESCRIPTION OF EMBODIMENTS

The following describes embodiments of this application with reference to the accompanying drawings in embodiments of this application.

In the specification, claims, and accompanying drawings of this application, the terms "first", "second", "third", "fourth", and the like are intended to distinguish between different objects but do not indicate a particular order. In addition, terms such as "including" and "having" and any other variants thereof are intended to cover a non-exclusive inclusion. For example, a process, a method, a system, a product, or a device that includes a series of steps or units is not limited to the listed steps or units, but optionally further includes an unlisted step or unit, or optionally further includes another inherent step or unit of the process, the method, the product, or the device.

"An embodiment" described in the specification indicates that a particular feature, structure or property described with reference to embodiments may be included in at least one embodiment of this application. The phrase appearing at various locations in this specification does not necessarily refer to a same embodiment, and is not an independent or alternative embodiment mutually exclusive to another embodiment. A person skilled in the art explicitly and implicitly understands that embodiments described in this specification may be combined with other embodiments.

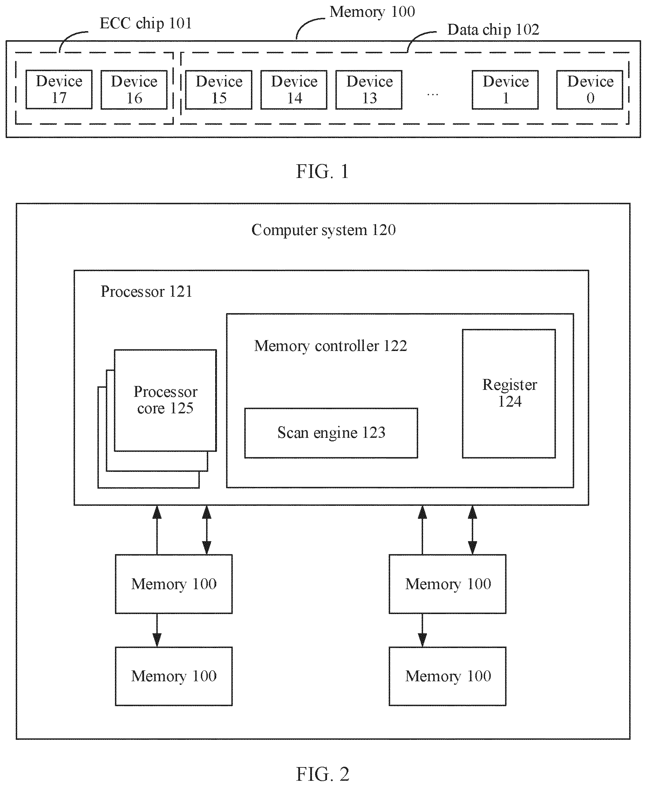

First, some terms in embodiments of this application are described, to help a person skilled in the art have a better understanding.
1. Cache line (cache line): A cache line refers to a size of a piece of data cached by a cache module (cache unit) in a processor. A value of a cache line varies with a different processor. Values of cache lines in mainstream computers and servers are 64 Bytes (Bytes). Generally, data that can be cached and that is carried in a processor is also of the same size 64 Bytes.
2. Memory chip (device): A memory chip is a core component of a memory module, is a storage medium of a memory, and directly affects performance of the memory. FIG. 1 is a schematic diagram of a memory according to an embodiment of this application. It can be learned from FIG. 1 that a memory 100 includes one or more memory chips. According to different content stored in the memory chips, the memory chips are further divided into data chips 101 and ECC chips 102, and usually include an X4 device, an X8 device, and an X16 device. X4, X8, and X16 respectively represent that an external data line of each memory chip is 4 lanes (lanes), 8 lanes, and 16 lanes.
3. Uncorrectable error (Uncorrectable Error, UCE): An uncorrectable error is an error that cannot be corrected in first memory data within a preset time period or a preset quantity of times. To be specific, in an error correction algorithm provided in a current technology, it is specified that if error correction on the memory data can be completed within the preset quantity of times or the preset time period, it is considered that the error is a correctable error (Correctable Error, CE), and the error may be directly corrected. If the error is an uncorrectable error, the error is not corrected.

For ease of understanding embodiments of this application, the following first analyzes and proposes a technical problem to be specifically resolved in this application.

It may be understood that a controller needs to first discover an error and then perform error correction. It can be learned from FIG. 1 that the memory includes two ECC chips. One memory chip is used to store cyclic redundancy check (Cyclic Redundancy Check, CRC) information for error detection, and the other memory chip is used to store parity (Parity) information for error correction configuration. The basic function of Parity is to detect whether bit flipping occurs in the memory data. The detection method is to count a quantity of 1s in the memory data. For even parity, if the quantity of 1s in the memory data is even, Parity is 0; otherwise, Parity is 1. Therefore, parity requires a bit to detect whether bit flipping occurs in the memory data (0 to 1 or 1 to 0). Certainly, the detection effect is the same for odd bits. However, when even bits are flipped. Parity is unknown.

The CRC can be used to check whether the read memory data is correct or incorrect. A divisor is designed, the memory data (dividend) is divided by the divisor, and then a quotient and a remainder are obtained. Generally, the remainder is smaller than the designed divisor. When memory data of one cache line is stored in a memory module, the controller may calculate a CRC value, and store the CRC value in a memory chip of the CRC. When the CRC value is read from the memory, the CRC value is calculated again and then compared with the CRC value read from the memory. If the values the same, it indicates that the read memory data does not change. Otherwise, it is considered that the read memory data is incorrect.

In this case, it is first assumed that a correctable error (correctable error, CE) occurs. The controller may reversely calculate data in the memory chip by using Parity information. However, memory chips need to be flipped one by one, and then a CRC obtained through recalculation is compared with a previously stored CRC. Generally, there are 18 memory chips. Therefore, the memory chips need to be flipped for 18 times. In other words, a preset quantity of times for error correction may be 18. If all the memory chips are flipped, and a CRC obtained through calculation does not match the previously stored CRC within the preset quantity of times of 18, it indicates that the memory data cannot be corrected within the preset quantity of times. Similarly, if a specific error correction algorithm is limited by time, and a CRC obtained through calculation within a preset time period is inconsistent with the previously stored CRC, it indicates that the memory data cannot be corrected within the preset time period. Therefore, a memory error may include an error that cannot be corrected in the memory data within the preset quantity of times. However, in a common technology, error correction on the foregoing memory error is generally abandoned, so that application requirements for ensuring data reliability cannot be met.

Based on the foregoing description, a technical problem to be resolved in this application may include: repairing a case in which first memory data cannot be corrected within a preset time period or a preset quantity of times without affecting normal data communication.

To resolve the foregoing technical problem, first, an embodiment of this application provides a system. FIG. 2 is a schematic diagram of a structure of a computer system according to an embodiment of this application. The computer system 120 shown in FIG. 2 may include a processor 121, a memory controller 122, a register 124, and a memory 100.

It should be noted that the memory controller 122 may be integrated into the processor 121, or may not be integrated into the processor 121. In addition, in addition to the components shown in FIG. 2, the computer system 120 may further include other components such as a communication interface and a disk used as an external memory. This is not limited in this embodiment of this application.

The processor (Processor) 121 is a computing core and a control core of the computer system 120, and the processor 121 may include one or more processor cores (cores) 125. The processor 121 may be an ultra-large-scale integrated circuit, and an operating system and another software program are installed in the processor 121, so that the processor 121 can implement access to the memory 100, the cache, and the disk, and the processor 121 can further process a data access request from outside the computer system 120. It may be understood that, in this embodiment of this application, the processor core 125 in the processor 121 may be a central processing unit (Central Processing unit, CPU), or may be another application-specific integrated circuit (Application Specific Integrated Circuit, ASIC). In an actual application, the computer system 120 may also include a plurality of processors.

The memory controller (Memory Controller) 122 is a bus circuit controller that controls the memory 100 inside the computer system 120 and is configured to manage and plan data transmission from the memory 100 to the processor core 125. Data may be exchanged between the memory 100 and the processor core 125 through the memory controller 122. The memory controller 122 may be an independent chip, and is connected to the processor core 125 by a system bus. The memory controller 122 may also be integrated into the processor 121 (as shown in FIG. 2), or may be built in a northbridge, or may be an independent memory controller chip. A specific location and an existence form of the memory controller 122 are not limited in this embodiment of this application. In an actual application, the memory controller 122 may control necessary logic to write data to the memory 100 or read data from the memory 100. The memory controller 122 may be a memory controller in a processor system such as a general-purpose processor, a dedicated accelerator, a GPU, an FPGA, or an embedded processor.

The memory 100 is a main memory of the computer system 120, and the memory 100 may be connected to the processor 121 by a double rate (double data rate, DDR) bus. The memory 100 is generally used to store various software running in the operating system, input and output data, information exchanged with the external memory, and the like. To improve an access speed of the processor 121, the memory 100 needs to have an advantage of a high access speed. In a conventional computer system architecture, a dynamic random access memory (Dynamic Random Access Memory, DRAM) is generally used as the memory 100. The processor 121 can access the memory 100 at a high speed through the memory controller 122, and perform a read operation and a write operation on any storage unit in the memory 100.

The memory controller 122 includes a scan engine 123. In an actual application, when a memory channel is idle, in other words, when the memory controller does not perform a read operation and a write operation on the memory 100 through the memory channel, the memory controller may control the scan engine 123 to scan all cache line (cache line) data in the memory 100. If error correction can be performed on a piece of cache line data within a preset time period or a preset quantity of times, the scan engine 123 may perform error correction on the piece of cache line data and write back the data. If a piece of cache line data cannot be corrected within a preset time period or a preset quantity of times, it indicates that a memory error exists in the piece of cache line data, and the scan engine 123 may mark the piece of cache line data with a first tag, and then write back the cache line data. It may be understood that, the first tag identifies an error that cannot be corrected in a piece of cache line data within a preset time period or a preset quantity of times.

The memory controller 122 may further include a register 124. If the memory controller 122 finds that a memory error exists in a piece of cache line data, the memory controller 122 may store, in the register, an address of the memory data having the memory error. It may be understood that the register may store addresses of one or more pieces of memory data having a memory error.

Therefore, when the memory channel is idle, the memory controller 122 determines that the memory data stored in the memory 100 has a memory error, and the memory controller 122 may read the memory data having the memory error based on the address stored in the register 124, so that memory error correction can be performed on the memory data when the memory channel is idle, and the corrected memory data is written back to the corresponding memory.

After error correction on data in which a UCE error exists is completed, the memory controller 122 releases a corresponding address stored in the register 124.

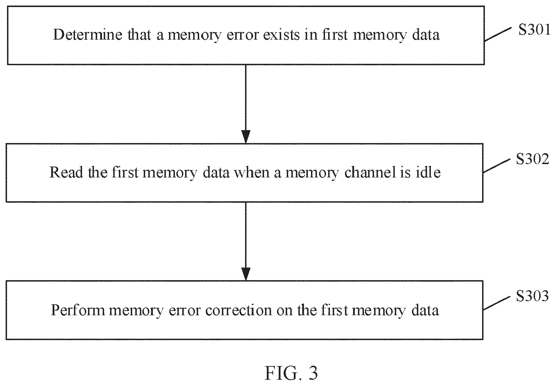

FIG. 3 is a schematic flowchart of a memory error correction method according to an embodiment of this application. The method is applied to the computer system 120 shown in FIG. 2. The method includes but is not limited to the following steps.

Step S301: Determine that a memory error exists in first memory data.

Specifically, in a memory, because a memory bit width is generally wide, for example, 32 bits or 64 bits, and each memory chip (Device) is generally 4 bits or 8 bits, a plurality of memory chips need to be connected in parallel, to achieve a required memory bit width. When writing data into the memory, a CPU writes, based on a data bit width of the CPU, bit values of data bits of the data into parallel memory chips simultaneously, and further generates a check code based on a preset algorithm by using the bit values of the data bits. Once any one of the memory chips fails, the memory controller may reconstruct "lost" data in the failed memory chip based on the check code and bit values of data bits stored in other memory chips, so that the computer system can continue to work normally. If the "lost" data in the failed memory chip cannot be constructed within a preset time period or a preset quantity of times, it is considered that the first memory data has a memory error. It may be understood that the memory error may also include error data bits distributed in two or more different memory chips. For example, bit flipping occurs in bit values of data bits in a first memory chip, bit flipping occurs in bit values of data bits in a second memory chip, and bit flipping occurs in bit values of data bits in a third memory chip.

In a possible implementation, after determining that a memory error exists in the first memory data, the memory controller may mark the first memory data by using a first tag (for example, a Posion). It may be understood that the first tag identifies that a memory error exists in the first memory data.

In a possible implementation, after determining that the memory error exists in the first memory data, the memory controller may store a first address of the first memory data in the register. It may be understood that there may be a plurality of pieces of memory data having a memory error. Therefore, the register may store addresses of the plurality of pieces of memory data having a memory error.

Further, after determining that the memory error exists in the first memory data, the memory controller may read the first memory data into an internal static random access memory (Static Random-Access Memory, SRAM) for temporary storage.

Step S302: Read the first memory data when a memory channel is idle.

Specifically, when the memory channel is idle, the memory controller may scan the memory by using a scan engine, to check whether a memory error exists in data in the memory. If it is determined that a memory error exists in the first memory data, the first memory data may be read.

In a possible implementation, the memory controller may read the first memory data from the memory based on the first address stored in the register. If a memory error flag exists in the first memory data, it indicates that a memory error exists in the first memory data, and the memory controller may read the first memory data.

In a possible implementation, when the memory controller does not detect that a read operation or a write operation is performed on the first memory data, the memory controller may read the first memory data based on the first address stored in the register.

Step S303: Perform memory error correction on the first memory data.

Specifically, when the memory controller reads the first memory data, the memory controller may perform memory error correction on the first memory data based on an error correction algorithm. Further, if the first memory data is stored in the internal SRAM, the memory controller may perform memory error correction (for example, bit flipping and CRC verification) on the first memory data based on the error correction algorithm when the memory channel is idle. Still further, when the memory channel is idle, if the memory controller finds, through scanning by using the scan engine, the first memory data having the memory error, the memory controller may perform memory error correction on the first memory data based on the error correction algorithm.

In a possible implementation, if the memory controller reads the first memory data based on the address in the register, and the first memory data has a first tag memory error correction is performed on the first memory data based on the error correction algorithm.

In a possible implementation, if the memory controller detects, in a process of performing memory error correction on the first memory data, a case in which a write operation is performed on the first memory data, it indicates that the first memory data is overwritten by other data. The memory controller may stop error correction, and release space that is in the register and that is used to store the first address. If the memory controller detects, in the process of performing memory error correction on the first memory data, a case in which a read operation is performed on the first memory data, it indicates that the first memory data is already used. The memory controller may stop error correction, report an error to an upper-layer software, and wait for a decision of the upper-layer software.

Therefore, in a process of performing error correction on the first memory data, the memory controller may detect whether a read operation or a write operation is performed on the first memory data. If the memory controller does not detect that a read operation or a write operation is performed on the first memory data, the memory controller may continue to perform memory error correction on the first memory data based on the error correction algorithm

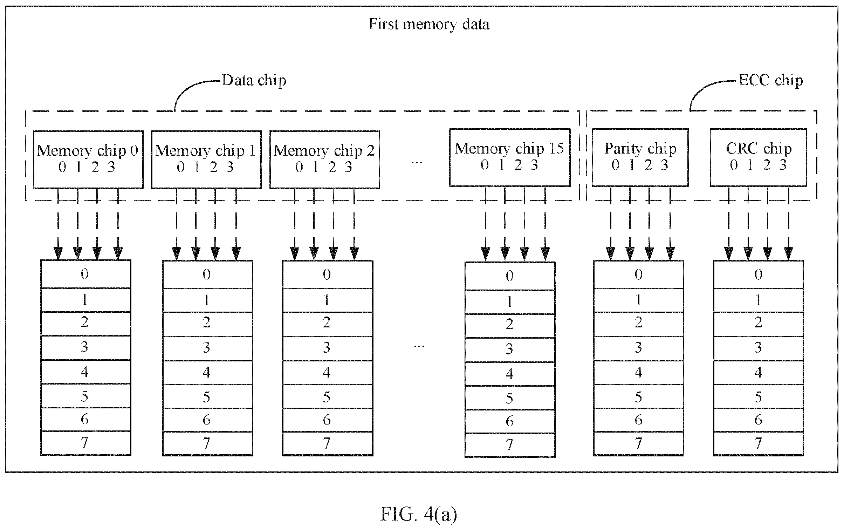

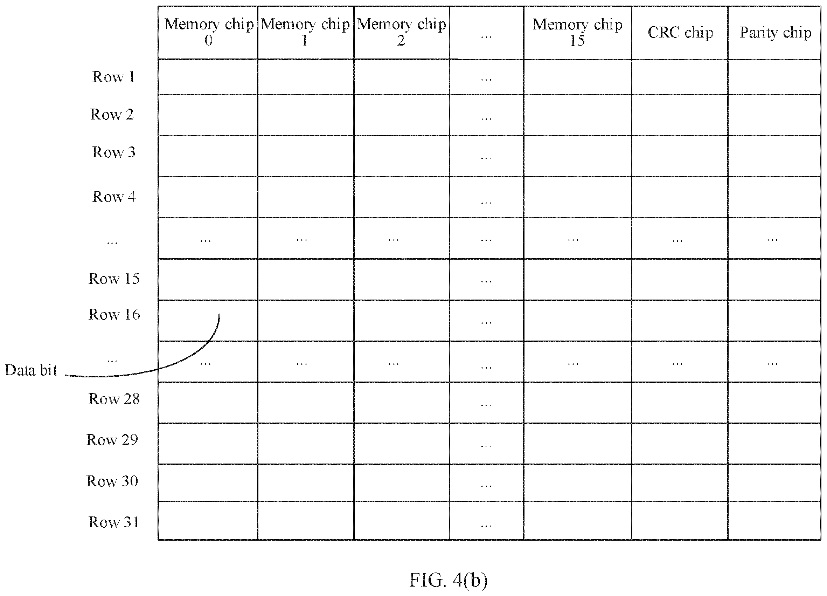

In a possible implementation, FIG. 4(a) and FIG. 4(b) are schematic diagrams of performing memory error correction on memory data according to an embodiment of this application. It may be understood that, an error that cannot be corrected in first memory data within a preset time period or a preset quantity of times may be that data in which bit flipping occurs is distributed in two or more memory chips. A size of a piece of cache line data cached in a processor varies with the processor, and therefore, a size of memory data also varies with the processor. Values of cache lines in current mainstream personal computers and servers are 64 Bytes (Bytes). Therefore, memory data that can be cached and that is carried in the processor is also of the same size 64 Bytes. Therefore, FIG. 4(a) and FIG. 4(b) are described by using an example in which the size of the first memory data is 64 Bytes. It can be learned from FIG. 4(a) that the first memory data includes data chips and ECC chips, the data chips include 16 memory chips (which are respectively a memory chip 0, a memory chip 1, a memory chip 2, ..., and a memory chip 15), and the ECC chips include a parity chip and a CRC chip. When a data line of the memory chip is 4 lanes, each memory chip needs to provide eight pieces of data at a time, and each piece of data includes 4-bit data provided by each memory chip. Therefore, memory data of a size of 4×16×8=64 Bytes can be obtained. Therefore, the first memory data may include eight pieces of data provided by each memory chip.

A schematic diagram shown in FIG. 4(b) may be obtained by arranging data provided by each memory chip in the first data by row. Each data bit in FIG. 4(b) represents one bit. Therefore, each column in the first data corresponds to data of a size of 32 bits provided by the memory chip, and each row corresponds to data provided by each data line of all memory chips in each piece of data provided by the memory chip. The memory error includes error data bits distributed in two or more different memory chips. In other words, bit flipping occurs in any two of the memory chip 0, the memory chip 1, the memory chip 2, ..., and the memory chip 15. For the foregoing memory error, the memory controller may divide the first memory data into two or more parts. For example, 32 bits may be evenly divided into two parts, four parts, or eight parts by column, and each part includes a data bit corresponding to each memory chip. In other words, row data of each part includes a data bit corresponding to each data line of all memory chips. It may be understood that there are different degrees of error correction capabilities, and a finer part obtained through division indicates a higher error correction capability.

It is assumed that error data bits are distributed in different memory chips in different parts. Therefore, the memory controller may first flip the first memory data bit in the first part and keep the flipped data unchanged. To be specific, the memory controller may select a first data bit from the first part based on the parity chip, flip the bit of the first data bit based on the parity chip corresponding to the first memory data bit, and keep the bit-flipped data unchanged. The memory controller then sequentially flips a plurality of second data bits in the second part until CRC is successfully performed on the data obtained through flipping. The first part is any one of the two or more parts, and the second part includes a part of the two or more parts except the first part.

It is assumed that the first memory data is divided into four parts, which are respectively a first part, a second part, a third part, and a fourth part. The memory controller may first flip a first data bit in the first part, keep flipped data unchanged, and then sequentially flip a plurality of second data bits in the second part, the third part, and the fourth part. The flipping the second data bits in the second part, the third part, and the fourth part may be understood as sequentially flipping the plurality of second data bits in the second part, the third part, and the fourth part. After each flip is completed, whether the error correction is correct may be determined by using a CRC chip. It is then ensured that flipping of a first data bit in the second part remains unchanged, and a plurality of second data bits in the first part, the third part, and the fourth part are sequentially flipped. It is ensured that flipping of a first data bit in the third part remains unchanged, and second data bits in the first part, the second part, and the fourth part are sequentially flipped. It is ensured that flipping of a first data bit in the fourth part remains unchanged, and second data bits in the first part, the second part, and the third part are sequentially flipped.

For example, the first memory data shown in FIG. 4(b) is divided into two parts. Therefore, the first part includes data corresponding to the first row, the second row, the third row, the fourth row, ..., and the fifteenth row, and the second part includes data corresponding to the sixteenth row, ..., the twenty-eighth row, the twenty-ninth row, the thirty-first row, and the thirty-first row. It is assumed that flipping occurs in two pieces of data. One of the two pieces of data appears in the first part, and the other appears in the second part. The memory controller may first ensure that flipping of the data bits in each row in the first part remains unchanged based on the parity chip, and then sequentially flip the data bits in each row in the second part based on the parity chip. Each time the data bits in a row in the second part are flipped, a CRC chip may be used to verify whether the flip is correct. If the flip is verified to be correct, the memory error correction is stopped; and if the flip is verified to be incorrect, the error correction continues. To be specific, for the first time, it is ensured that flipping of data bits in the first row in the first part remains unchanged, and data bits in each row in the second part are sequentially flipped. For the second time, it is ensured that flipping of data bits in the second row in the first part remains unchanged, and data bits in each row in the second part are sequentially flipped. The memory error correction is stopped until the data bits of each row in the first part are flipped completely, or the flipping is verified to be correct based on the CRC chip.

It should be noted that the memory error correction method provided in embodiments of this application is applicable to another error correction algorithm, and is not limited to that provided in embodiments of this application.

The foregoing describes in detail the method in embodiments of this application. The following provides an apparatus in embodiments of this application.

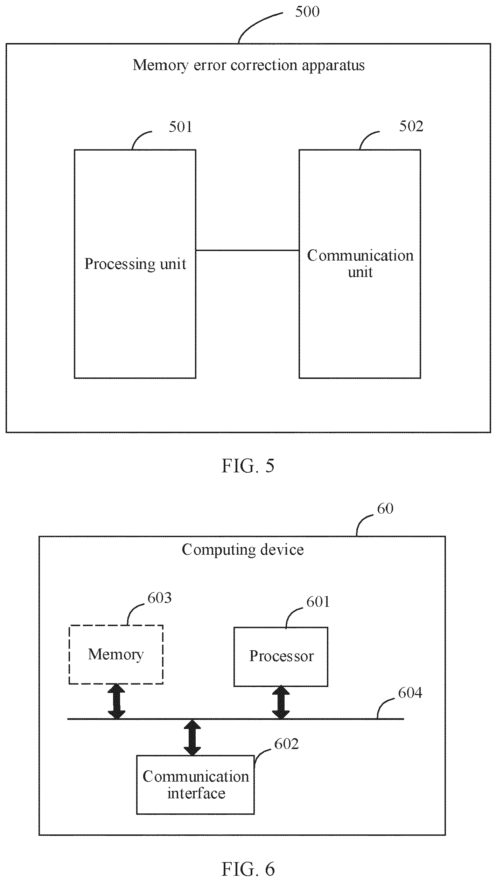

FIG. 5 is a schematic diagram of a structure of a memory error correction apparatus 500 according to an embodiment of this application. The memory error correction apparatus 500 may be a server or user equipment, or may be a component in a server or user equipment, for example, a chip, a software module, or an integrated circuit. The memory error correction apparatus 500 is configured to implement the foregoing memory error correction method, for example, the memory error correction method in the embodiment shown in FIG. 3.

In a possible implementation, the memory error correction apparatus 500 may be the memory controller in the foregoing embodiment.

In a possible design, the memory error correction apparatus 500 includes a processing unit 501 and a communication unit 502.

In a possible implementation, the processing unit is configured to determine that a memory error exists in first memory data, where the memory error includes an error that cannot be corrected in the first memory data within a preset time period or a preset quantity of times.

The communication unit is configured to read the first memory data when a memory channel is idle.

The processing unit is further configured to perform memory error correction on the first memory data.

In another possible implementation, the processing unit is further configured to:
store a first address of the first memory data in a register of a memory controller.

In still another possible implementation, the communication unit is specifically configured to:
read the first memory data based on the first address stored in the register.

In still another possible implementation, the processing unit is specifically configured to:
perform memory error correction on the first memory data when a first tag exists in the read first memory data, where the first tag identifies that the memory error exists in the first memory data.

In still another possible implementation, the processing unit is specifically configured to:
stop performing memory error correction on the first memory data when a read operation or a write operation is performed on the read first memory data in a process of performing memory error correction on the first memory data.

In still another possible implementation, the processing unit is specifically configured to:
divide the first memory data into two or more parts, where each part includes data bits corresponding to a plurality of memory chips; and
flip a first data bit in a first part, keep flipped data unchanged, and sequentially flip a plurality of second data bits in a second part until data obtained through flipping is successfully checked, where the first part is any one of the two or more parts, and the second part includes a part of the two or more parts except the first part.

It should be noted that, for implementation of each unit, refer to corresponding descriptions of embodiments of the memory error correction method shown in FIG. 3.

FIG. 6 is a schematic diagram of a structure of a computing device 60 according to an embodiment of this application. The computing device 60 may be an independent device (for example, one or more of a server or user equipment), or may be a component (for example, a chip, a software module, or a hardware module) in an independent device. The computing device 60 may include at least one processor 601, and optionally, may further include at least one memory 603. Further optionally, the computing device 60 may further include a communication interface 602, and further optionally, may further include a bus 604. The processor 601, the communication interface 602, and the memory 603 are connected by the bus 604.

The processor 601 is a module for performing an arithmetic operation and/or a logical operation, and may be specifically one or a combination of a plurality of processing modules such as a central processing unit (central processing unit, CPU), a graphics processing unit (graphics processing unit, GPU), a microprocessor (microprocessor unit, MPU), an application-specific integrated circuit (Application Specific Integrated Circuit, ASIC), a field programmable gate array (Field Programmable Gate Array, FPGA), a complex programmable logic device (Complex programmable logic device, CPLD), a coprocessor (assisting the central processing unit to complete corresponding processing and application), and a microcontroller unit (Microcontroller Unit, MCU).

The communication interface 602 may be configured to provide information input or output for the at least one processor, and/or the communication interface 602 may be configured to receive data sent externally and/or send data to the outside, and may be a wired link interface including an Ethernet cable, or may be a wireless link (Wi-Fi, Bluetooth, universal wireless transmission, an in-vehicle short-distance communication technology, or another short-distance wireless communication technology) interface. Optionally, the communication interface 602 may further include a transmitter (for example, a radio frequency transmitter or an antenna), a receiver, or the like coupled to the interface.

The memory 603 is configured to provide storage space, and the storage space may store data such as an operating system and a computer program The memory 603 may be one or a combination of a plurality of memories such as a random access memory (random access memory, RAM), a read-only memory (read-only memory, ROM), an erasable programmable read-only memory (erasable programmable read only memory, EPROM), and a portable read-only memory (compact disc read-only memory, CD-ROM).

The at least one processor 601 in the computing device 60 is configured to perform the foregoing memory error correction method, for example, the memory error correction method described in the embodiment shown in FIG. 3.

Optionally, the processor 601 may be a processor (referred to as a dedicated processor for ease of differentiation) specially configured to perform these methods, or may be a processor that performs these methods by invoking a computer program, for example, a general-purpose processor. Optionally, the at least one processor may further include both a dedicated processor and a general-purpose processor. Optionally, when the computing device includes at least one processor 601, the computer program may be stored in the memory 603.

In a possible implementation, the at least one processor 601 in the computing device 60 is configured to execute invoked computer instructions to perform the following operations: determining that a memory error exists in first memory data, where the memory error includes an error that cannot be corrected in the first memory data within a preset time period or a preset quantity of times; reading the first memory data when a memory channel is idle; and performing memory error correction on the first memory data.

In a possible implementation, the processor 601 is further configured to store the first address of the first memory data in a register of a memory controller through the communication interface 602.

In a possible implementation, the processor 601 is specifically configured to, when the memory channel is idle, read the first memory data based on the first address stored in the register.

In a possible implementation, the processor 601 is specifically configured to perform memory error correction on the first memory data when a first tag exists in the read first memory data, where the first tag identifies that the memory error exists in the first memory data.

In a possible implementation, the processor 601 is specifically configured to stop performing memory error correction on the first memory data when a read operation or a write operation is performed on the read first memory data in a process of performing memory error correction on the first memory data.

In a possible implementation, the processor 601 is specifically configured to: divide the first memory data into two or more parts, where each part includes data bits corresponding to a plurality of memory chips; and
flip a first data bit in a first part, keep flipped data unchanged, and sequentially flip a plurality of second data bits in a second part until data obtained through flipping is successfully checked, where the first part is any one of the two or more parts, and the second part includes a part of the two or more parts except the first part.

In a possible implementation, the processor 601 is further configured to write the first memory data on which memory error correction is performed back to a memory unit corresponding to the first address through the communication interface 602.

This application further provides a computer-readable storage medium. The computer-readable storage medium stores instructions. When the instructions are run on at least one processor, the foregoing version management method is implemented, for example, the memory error correction method shown in FIG. 3.

This application further provides a computer program product. The computer program product includes computer instructions. When the computer program product is executed by a computing device, the foregoing version management method is implemented, for example, the memory error correction method shown in FIG. 3.

In embodiments of this application, the word "example" or "for example" or the like is used to represent giving an example, an illustration, or a description. Any embodiment or design scheme described as an "example" or "for example" in this application should not be explained as being more preferred or having more advantages than another embodiment or design scheme. Exactly, use of the word "example", "for example", or the like is intended to present a related concept in a specific manner.

"At least one" described in embodiments of this application refers to one or more, and "a plurality of" refers to two or more. "At least one of the following items (pieces)" or a similar expression thereof refers to any combination of these items, including any combination of singular items (pieces) or plural items (pieces). For example, at least one item (piece) of a, b, or c may represent a, b, c, (a and b), (a and c), (b and c), or (a and b and c), where a, b, and c may be singular or plural. The term "and/or" describes an association relationship between associated objects, and represents that three relationships may exist. For example, A and/or B may represent the following cases: Only A exists, both A and B exist, and only B exists, where A and B may be singular or plural. A character "/" generally indicates an "or" relationship between the associated objects.

In addition, unless otherwise stated, ordinal numbers such as "first" and "second" are used in embodiments of this application to distinguish between a plurality of objects, but are not used to limit an order, a time sequence, a priority, or an importance degree of the plurality of objects. For example, first user equipment and second user equipment are merely for ease of description, but do not indicate differences in structures, importance degrees, and the like of the first user equipment and the second user equipment. In some embodiments, the first user equipment and the second user equipment may alternatively be the same equipment.

According to the context, the term "when" used in the foregoing embodiments may be interpreted as a meaning of "if', "after", "in response to determining", or "in response to detecting". The foregoing descriptions are merely optional embodiments of this application, but are not intended to limit this application. Any modification, equivalent replacement, or improvement made without departing from the concept and principle of this application should fall within the protection scope of this application.

A person of ordinary skill in the art may understand that all or some of the steps of embodiments may be implemented by hardware or a program instructing related hardware. The program may be stored in a computer-readable storage medium. The storage medium may include: a read-only memory, a magnetic disk, or an optical disc.

## Claims

1. A memory error correction method, comprising:
determining that a memory error exists in first memory data, wherein the memory error comprises an error that cannot be corrected in the first memory data within a preset time period or a preset quantity of times;
reading the first memory data when a memory channel is idle; and
performing memory error correction on the first memory data.

2. The method according to claim 1, wherein before the determining that a memory error exists in first memory data, and after the reading the first memory data when a memory channel is idle, the method further comprises:
storing a first address of the first memory data in a register of a memory controller.

3. The method according to claim 2, wherein the reading the first memory data when a memory channel is idle comprises:
when the memory channel is idle, reading the first memory data based on the first address stored in the register.

4. The method according to any one of claims 1 to 3, wherein the performing memory error correction on the first memory data comprises: performing memory error correction on the first memory data when a first tag exists in the read first memory data, wherein the first tag identifies that the memory error exists in the first memory data.

5. The method according to any one of claims 1 to 3, wherein the performing memory error correction on the first memory data comprises:
stopping performing memory error correction on the first memory data when a read operation or a write operation is performed on the read first memory data in a process of performing memory error correction on the first memory data.

6. The method according to any one of claims 1 to 5, wherein the performing memory error correction on the first memory data comprises:
dividing the first memory data into two or more parts, wherein each part comprises data bits corresponding to a plurality of memory chips; and
flipping a first data bit in a first part, keeping flipped data unchanged, and sequentially flipping a plurality of second data bits in a second part until data obtained through flipping is successfully checked, wherein the first part is any one of the two or more parts, and the second part comprises a part of the two or more parts except the first part.

7. The method according to any one of claims 1 to 6, wherein after the performing memory error correction on the first memory data based on an error correction algorithm, the method further comprises:
writing the first memory data on which memory error correction is performed back to a memory unit corresponding to the first address.

8. A memory error correction apparatus, comprising:
a processing unit, configured to determine that a memory error exists in first memory data, wherein the memory error comprises an error that cannot be corrected in the first memory data within a preset time period or a preset quantity of times; and
a communication unit, configured to read the first memory data when a memory channel is idle, wherein
the processing unit is further configured to perform memory error correction on the first memory data.

9. The apparatus according to claim 8, wherein the processing unit is further configured to:
store a first address of the first memory data in a register of a memory controller.

10. The apparatus according to claim 9, wherein the communication unit is specifically configured to:
read the first memory data based on the first address stored in the register.

11. The apparatus according to claim 10, wherein the processing unit is specifically configured to:
perform memory error correction on the first memory data based on the error correction algorithm when a first tag exists in the read first memory data, wherein the first tag identifies that the memory error exists in the first memory data.

12. The apparatus according to claim 10, wherein the processing unit is specifically configured to:
stop performing memory error correction on the first memory data when a read operation or a write operation is performed on the read first memory data in a process of performing memory error correction on the first memory data.

13. The apparatus according to any one of claims 8 to 12, wherein the processing unit is specifically configured to:
divide the first memory data into two or more parts, wherein each part comprises data bits corresponding to a plurality of memory chips; and
flip a first data bit in a first part, keep flipped data unchanged, and sequentially flip a plurality of second data bits in a second part until data obtained through flipping is successfully checked, wherein the first part is any one of the two or more parts, and the second part comprises a part of the two or more parts except the first part.

14. The apparatus according to any one of claims 8 to 13, wherein the communication unit is further configured to:
write the first memory data on which memory error correction is performed back to a memory unit corresponding to the first address.

15. A computing device, wherein the computing device comprises a processor and a memory, wherein
the memory stores a computer program; and
when the processor executes the computer program, the computing device performs the method according to any one of claims 1 to 7.

16. A computer-readable storage medium, wherein the computer-readable storage medium stores instructions, and when the instructions are run on at least one processor, the method according to any one of claims 1 to 7 is implemented.
